Europäisches Patentamt

European Patent Office

Office européen des brevets

(19)

(11) Publication number: **0 100 206**
**A1**

# EUROPEAN PATENT APPLICATION

(12)

(21) Application number: 83304226.0

(22) Date of filing: 21.07.83

(51) Int. Cl.³: **C 23 C 13/08**, C 23 C 15/00,
C 23 F 1/08

(30) Priority: 22.07.82 US 400949

(43) Date of publication of application: 08.02.84
Bulletin 84/6

(84) Designated Contracting States: CH DE FR GB LI NL

(71) Applicant: OERLIKON-BUHRLE U.S.A. INC., One Penn
Plaza, New York, NY 10001 (US)

(72) Inventor: Egerton, E. James, 14 Courtland Road, Nashua
New Hampshire (US)
Inventor: Millikin, William E., 50 Newtown Road, Acton
Massachusetts (US)
Inventor: Baril, Richard L., 3 Alford Lane, Nashua New
Hampshire (US)
Inventor: Cook, Walter R., 5 Nevada Street, Nashua New
Hampshire (US)
Inventor: Nef, Alex, 8 Walton Road, Nashua New
Hampshire (US)

(74) Representative: Saunders, Harry et al, SAUNDERS &
DOLLEYMORE 2 Norfolk Road, Rickmansworth
Hertfordshire WD3 1JH (GB)

(54) **Apparatus for treating an article in a vacuum chamber.**

(57) An apparatus for controlling the temperature of a semicon-
ductor wafer in a plasma or vacuum environment comprises a
wafer support in the form of a head having a first fluid heat ex-
changer for selectively cooling or heating the head, a con-
format on the upper surface of the head for forming an hermetic
seal with a wafer pressed against the upper surface, and means
coating with a wafer on the upper surface to form a second
fluid heat exchanger for cooling the wafer, and clamp means
for clamping a wafer against the conformat.

-1-

APPARATUS FOR TREATING AN ARTICLE IN A VACUUM CHAMBER

This invention relates to the art of controlling the temperature of an article in a plasma or vacuum environment, and particularly to a method and apparatus for cooling a semiconductor wafer in a reactive ion etch system or an ion implantation system.

As recognised by U.S. patent no. 4 261 762 issued to Monroe L. King, in many applications where articles are heated in a vacuum chamber it is important to control the temperature of the articles during treatment. For example, in ion implantation of semiconductor wafers the high energy ion beam heats up the wafers and causes a number of undesirable side effects such as damage to photoresist coatings. A similar undesirable heating occurs in reactive ion etching systems. In ion implantation systems the absence of gas molecules in the vacuum environment virtually eliminates conductive paths for heat flow, with the result that in higher beam power systems radiation cooling is not sufficient to avoid undesirable wafer heating. Substantially the same is true in reactive ion etching systems where although an etchant gas mixture is used the gas concentration is quite low due to the system being carried out under vacuum at pressures typically between about 5 and about 200 millitorr (0.7 - 26.7 Pa). Efforts have been made to increase conductive heat transfer from the wafers by using a thermally conductive conformat, i.e., a soft pliable material, pressed against the wafers so as to maximise the contact area between them and thus facilitate conduction to a heat sink supporting the conformat and wafer. Such efforts hence have not been satisfactory and gave way to the concept, disclosed in said U.S. patent 4 261 762 of M.L. King, of clamping a wafer to a support member with a seal provided between the periphery of the wafer and the support so as to provide thermal conductivity to assist in controlling the wafer temperature. However, the heat dissipation achieved by the gas is not fully adequate, particularly where the treating process is reactive ion etching.

Accordingly, the primary object of this invention is to provide an improved method and apparatus for controlling the temperature of an article in a vacuum environment so as to overcome the shortcomings of prior known techniques.

Another object is to provide a method and apparatus for providing superior conductive heat transfer between an article being treated and an article support member in a vacuum environment by means of a fluid heat conducting medium.

A more specific object is to improve upon the method and apparatus disclosed in U.S. patent 4 261 762 in a way which may be utilised in various treating processes, including but not limited to reactive ion etching, plasma etching and ion implantation.

A further specific object is to provide a method and apparatus for controlling the temperature of an article in an ion beam environment which is arranged to facilitate transport of articles into and out of such environment.

Briefly stated the invention to be described in greater detail below involves means for releasably clamping an article to be treated against a support member, means for circulating a first cooling fluid between the article and support member so as to achieve superior heat transfer from the article to the support member, and means for circulating a second cooling fluid through portions of the support member so as to remove heat from the support member. In a preferred embodiment of the invention the support member is part of an electrode assembly which can be adjusted so as to vary the angular position of the support member.

Other features and many of the advantages of the invention are expressly stated, in or rendered obvious by, the following detailed description of a preferred embodiment of the invention with reference to the accompanying diagrammatic drawings, in which:

Figure 1 is a sectional view in side elevation of a reactive ion etching apparatus constituting a preferred embodiment of the invention;

Figure 2 is a top plan view of a flange forming part of the vacuum pumping housing;

Figure 3 is a plan view of a clamp plate forming part of the apparatus of Figure 1;

Figure 4 is a sectional view in elevation of the lower electrode assembly;

Figures 5 and 6 are top and bottom plan views of the pedestal plate of the lower electrode;

Figures 7 and 8 are top and bottom views of the middle cooling plate of the lower electrode;

Figures 9 and 10 are top and bottom plan views of the upper cooling plate of the lower electrode;

Figure 11 is a side elevation of the upper end of the clamp assembly;

Figure 12 is a side elevation of the upper end of the clamp assembly taken at right angles to Figure 11;

Figure 13 is an exploded perspective view of the upper end of the clamp assembly;

Figure 14 is a bottom view of the clamp top;

Figure 15 is a sectional view taken along line 15-15 of Figure 14;

Figure 16 is a bottom plan view of·a feedthrough cap member; and

Figure 17 is a schematic view illustrating the several positions of the clamp assembly.

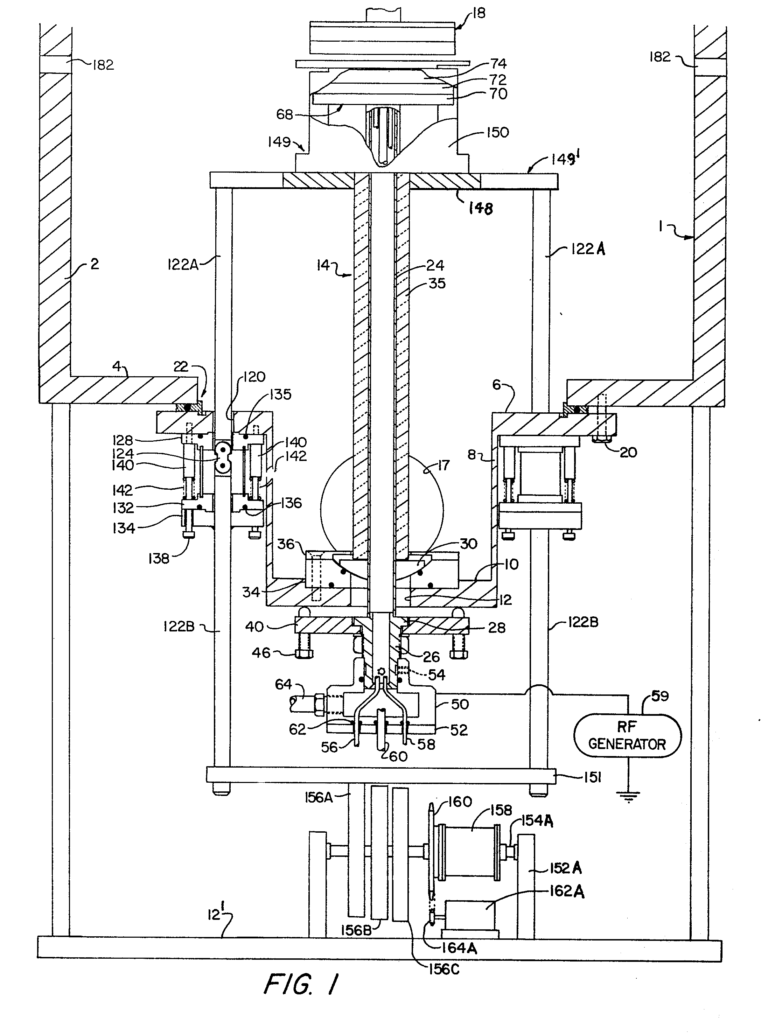

Turning now to Figure 1, the illustrated apparatus is an apparatus designed to carry out reactive ion etching in a vacuum chamber 1 which includes a cylindrical side wall 2, a top wall (not shown), an annular bottom wall 4 formed integrally with side wall 2, and a bottom wall closure comprising an annular flange section 6, a cylindrical neck section 8, and an annular bottom wall section 10. The annular bottom wall section 10 has a circular hole 12 to accommodate the lower electrode assembly 14 hereinafter described. The vacuum chamber 10 is supported above and secured to a base 12' by means of two or more support members 16.

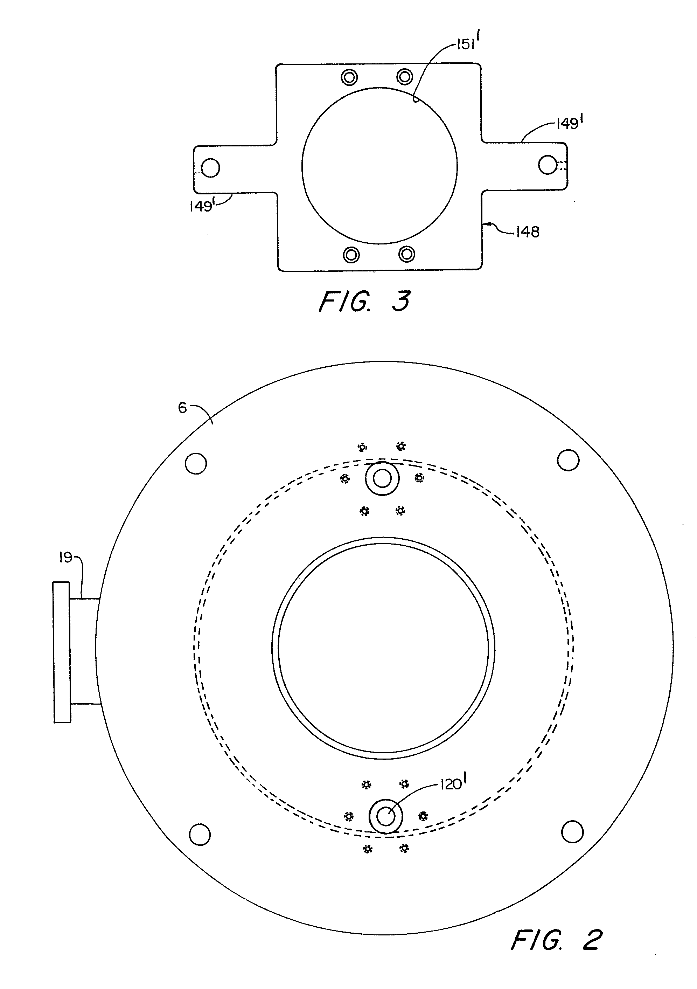

The chamber 1 is also provided with a port 17 (Figure 1) that has a tubular extension 19 (Figure 2) which is adapted to be connected to a vacuum pump of suitable design capable of lowering the pressure in the chamber 1 to the desired level, e.g., 5 to 200 millitorr (0.7 to 26.7 Pa). In the usual case the vacuum pump is a cryopump.

Mounted to and extending within the chamber 1 is an upper electrode 18. The construction of electrode 18 is not critical to and forms no part of the present invention. Electrode 18 may take various forms known to persons skilled in the art provided, however, that it must have a geometry and positioning conducive to the process being carried out in the vacuum chamber housing (see U.S. patents 4 297 162, 4 283 249, 3 971 684, 4 285 763, 4 283 249 and 3 940 506 for information regarding electrodes relevant to this invention). In the case of reactive ion etching, it is preferred that upper electrode 18 have a flat end surface confronting the upper end surface of lower electrode assembly 14.

The annular flange section 6 is secured to bottom wall 4 by a plurality of bolts 20 which are screwed into tapped holes in bottom wall 4. A conventional metal/elastomer hermetic seal assembly 22 is clamped between bottom wall 4 and flange 6.

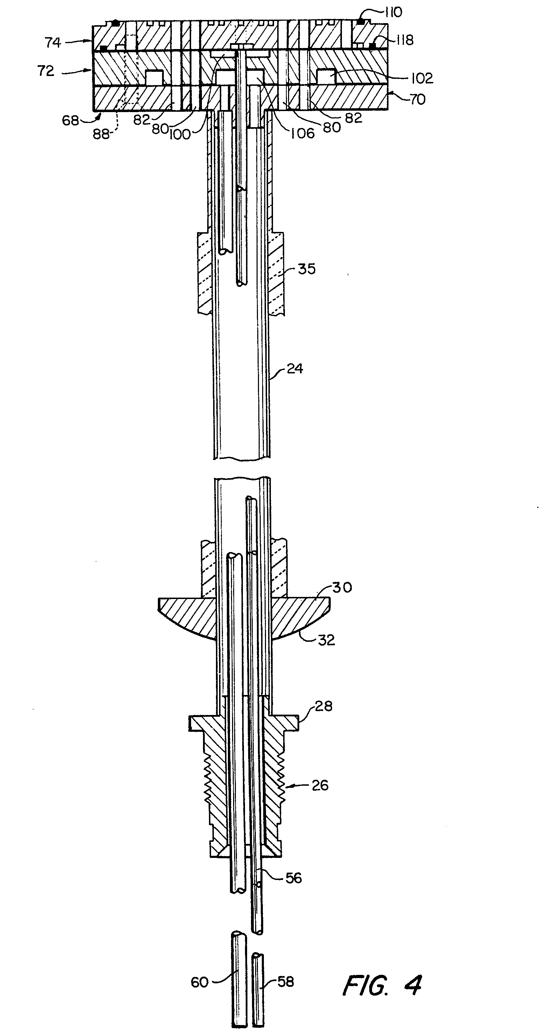

Referring now to Figures 1 and 4, the lower electrode assembly 14 comprises a hollow conductive metal tube 24 having its upper end secured to the lower electrode head assembly 68 and its lower end secured to a tube end fitting 26 which has a cylindrical cross-section but terminates in a rectangular flange 28. The lower electrode assembly 14 also includes a collar 30 attached to tube 24 a short distance from fitting 26. Collar 30 has a spherically curved lower surface 32. A two-piece cylindrical thermally and electrically insulating sleeve 35 surrounds and is attached to electrode tube 24. Collar 30 fits in a spherically curved depression in a plate 34 which fits in a recess in bottom wall section 10. A cover plate 36 overlies plate 34. Plates 34 and 36 are secured to one another and also to bottom wall section 10 by screws. Cover plate 36 has a centre hole which is oversized relative to insulating sleeve 35 so as to accommodate tilting movement of tube 24. Cover plate 36 overlies collar 30 and coacts therewith to limit movement of the lower electrode assembly 14 toward upper electrode 18.

Still referring to Figures 1 and 4, the lower electrode assembly is held against plate 34 by means of a levelling plate 40 which has a circular hole to accommodate the cylindrical portion of tube end fitting 26 and a rectangular hole sized to snugly accommodate the rectangular flange 28 of tube end fitting 26. The latter has a screw thread on a portion of its centre surface to accommodate a nut 42 which acts through a washer 44 to hold levelling plate 40 tight against flange 28. Plate 40 has three equally spaced threaded holes to accommodate three levelling screws 46 which bear against the bottom end surface of bottom wall section 10. By manipulation of screws 46 it is possible to move the axis of tube 24 into and out of parallelism with the side wall 2 of the vacuum chamber 1.

Attached to the lower end of tube end fitting 26 is a feedthrough assembly comprising a hollow electrically conductive feedthrough body 50 and a feedthrough end cap 52. Feedthrough body 50 is secured to tube end fitting 26 by a set screw 54. The lower end wall of feedthrough body 50 and the end cap 52 each have three holes to accommodate two smaller diameter gas conduits 56 and 58 and a larger oil conduit 60. Insulating sleeves 62 in end cap 52 surround conduits 56, 58 and 60 and provide electric insulation and hermetic seals around those conduits. Feedthrough body 50 has a threaded side port to accommodate a second oil conduit 64. Conduits 56 and 58 are connected to a source of a cooling gas, such as helium (not shown), via a suitable circulating pump (also not shown). Conduits 60 and 64 are connected to a source of cooling oil (not shown) via a suitable circulating pump (also not shown).    Conduits 56, 58 and 60 extend up to the top end of tube 24 and are connected to the electrode head assembly 68 (Figures 1 and 4).    In this particular embodiment of the invention, feedthrough body 50 (and hence the lower electrode 14) is coupled electrically to the high potential side of an RF generator 59.    The other side of generator 59 is connected to ground.    In such case the upper electrode 18 is grounded.    However, it is to be understood that for some selected applications, electrode 18 may be connected to the high potential side of RF generator 59 and feedthrough body 50 and hence the lower electrode 14 may be grounded.

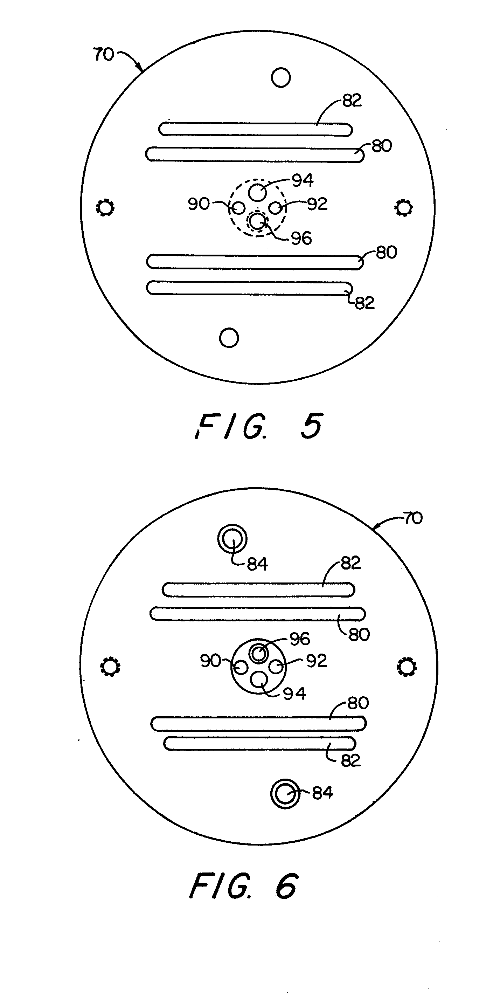

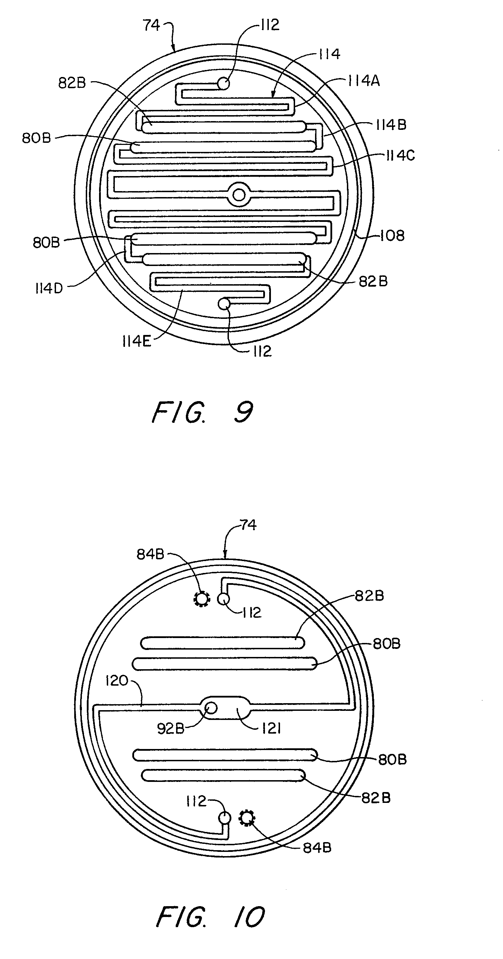

The electrode head assembly 68 comprises three conductive metal plates 70, 72 and 74 arranged one below the other in the order named (it is to be noted that in Figures 5-10, plates 70, 72 and 74 are displaced 90° from the position shown in Figure 4). Lower plate 70 serves as pedestal for plates 72 and 74 as well as being the lower section of an oil cooling assembly.    Plate 72 is brazed to plate 70 and is the upper section of the oil cooling assembly as well as serving as a support for plate 74..    The latter is the face plate for the lower electrode assembly and serves as a gas cooling path member and a heat sink.

Referring now to Figures 4-6, plate 70 has a circular stem 78 that extends within and is secured to the upper end of tube 24 in a suitable manner, e.g., by brazing or welding.    Plate 70 has two pairs of elongate through holes 80, 82 disposed in parallel position on opposite sides of its centre line, plus two through holes 84 adjacent its periphery to accommodate screws 88 (Figure 4) which are used to secure it to plates 72 and 74.    At its centre plate 70 has four through holes 90, 92, 94, 96. Conduits 56 and 58 extend through holes 90 and 92 respectively, while conduit 60 is secured in hole 96. Hole 94 is open and communicates with the interior of tube 24.

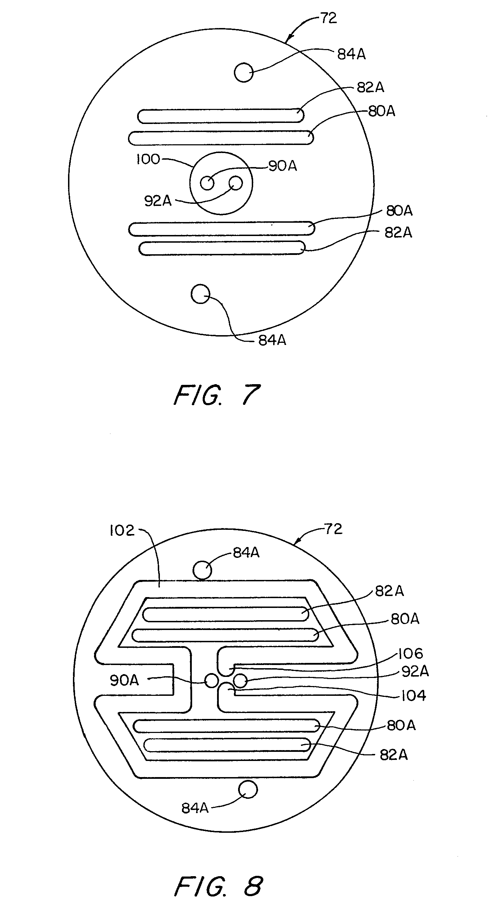

Turning now to Figures 4, 7 and 8, plate 72 has two pairs of elongate through holes 80A and 82A that are identical in size and shape and also are aligned with holes 80 and 82 of plate 70. Plate 72 also has two through holes 84A that are aligned with holes 84 of plate 70 and two through holes 90A and 92A that are identical in size and location to holes 90 and 92 of plate 70. On its upper side plate 72 has a circular counterbore or depression 100. On its underside plate 72 has a groove 102 that has a tortuous configuration arranged so that it substantially fully surrounds the elongate holes 80A and 82A and extends into all four quadrants of the plate. The two ends 104 and 106 of groove 102 are spaced from but confront one another between holes 90A and 92A. They also terminate over and in line with holes 94 and 96 of plate 70 and are rounded as shown in Figure 8, with the radius of curvature slightly larger than the radius of holes 94 and 96. As a result groove 102 and the adjacent surface of plate 70 define a convoluted or tortuous passageway linking holes 94 and 96. Thus oil introduced via line 60 will flow between plates 70 and 72 formed by groove 102 and then flow back out of the electrode head 68 via hole 94, the interior of tube 24 and exit conduit 64.

Turning now to Figures 4, 9 and 10, the underside of plate 74 has two threaded blind holes 84B which are threaded to receive the screws 88 (Figure 4) which secure it to plate 72. Plate 74 also has two pairs of through holes 80B and 82B which have the same size and shape and are aligned with holes 80 and 82 of plate 70 and holes 80A and 82A of plate 72. Plate 74 also has a through hole 92B which has the same size as and is aligned with holes 92 and 92A of plates 70 and 72 respectively.

On its upper side plate 74 has a groove 108 near its periphery which accommodates a resilient O-ring 110 (Figure 4). Plate 74 has two through holes 112 at diametrically opposed locations and in its top surface it has a groove 114 which comprises a first section 114A connecting one of the holes 112 to one of the holes 82B, a second section 114B connecting that hole 82B to the adjacent hole 80B, a third section 114C connecting that hole 80B to the second like hole 80B, a fourth section 114D connecting that second hole 80B to the second hole 82B, and a fifth section 114E connecting that second hole 82B to the second hole 112. Groove section 114C intersects hole 94B and is slightly enlarged around that hole as shown at 115.

On its bottom side plate 74 has another circular groove 116 near its periphery which accommodates an O-ring 118 (Figure 4) to provide a seal between it and plate 72. The underside of plate 74 also has a convoluted or tortuous shaped groove 120 that starts at one hole 112, extends close to the periphery of the plate for about 90°, then proceeds across the plate, and then extends close to the periphery of the plate for about 90° and stops at the second hole 112. Groove 120 intersects hole 92B and is enlarged as shown at 121 in the region of hole 92B so as to provide a passageway communicating with hole 90A of plate 72.

Conduit 56 extends through holes 92A and 92B in plates 72 and 74 and terminates flush with the surface forming the bottom of groove 114. Conduit 58 extends through the hole 90A of plate 72 and terminates flush with the bottom of cavity 100. Cavity 100 of plate 72 is aligned with the enlarged section 121 of groove 120. As a consequence, if a wafer covers and is clamped against the upper side of plate 74, a cooling gas introduced via conduit 56 will pass into the passageway formed between the wafer and the upper surface of plate 74, by groove 114, flow to the ends of groove 114 and pass through holes 112 into groove 120, pass along groove 120 to the enlarged area 121 and then flow back out of the lower electrode head via conduit 58 in hole 92A.

Referring now to Figures 1 and 2, the annular flange section 6 of the vacuum chamber has two diametrically opposed holes 120' to accommodate two clamp guide rod assemblies 122 each consisting of upper and lower clamp guide rods 122A and 122B pivotally connected by a link 124. Guide rods 122A are connected to a clamp plate 148 which forms part of a work clamp assembly 149, while guide rods 122B are connected to a cam plate 151, as described below. Attached to flange section 6 at each hole 120 is a bellows assembly 126 comprising an annular stationary bellows support flange 128 which is bolted to flange 6, a flexible metal bellows 130 welded to support flange 128, an annular movable bellows support flange 132 welded to the lower side of the bellows, an annular bellows drive plate 134 bolted to support flange 132 and welded to guide rod 122B, an O-ring 135 in a groove in support flange 128 engaging flange section 6, another O-ring 136 in a groove in the underside of support flange 128 engaging drive plate 134, a pair of diametrically opposed guide bolts 138 slidably extending through aligned holes in drive plate 134 and support flanges 132 and 128 and secured into tapped holes in flange section 6, tubular spacers 140 slidably surrounding bolts 138, and compression springs 142 engaging and extending between spacers 140 and support flange 132. Bolts 138 are long enough to allow the bellows to flex to the extent required to accommodate movement of the work clamp assembly in the manner hereinafter described. Springs 142 urge support flanges 128 and 132 to extend the bellows longitudinally. As is believed obvious, the two bellows assemblies allow the clamp guide rod assemblies to move up and down as required while preventing leakage of fluid pressure via the holes 120 in flange section 6.

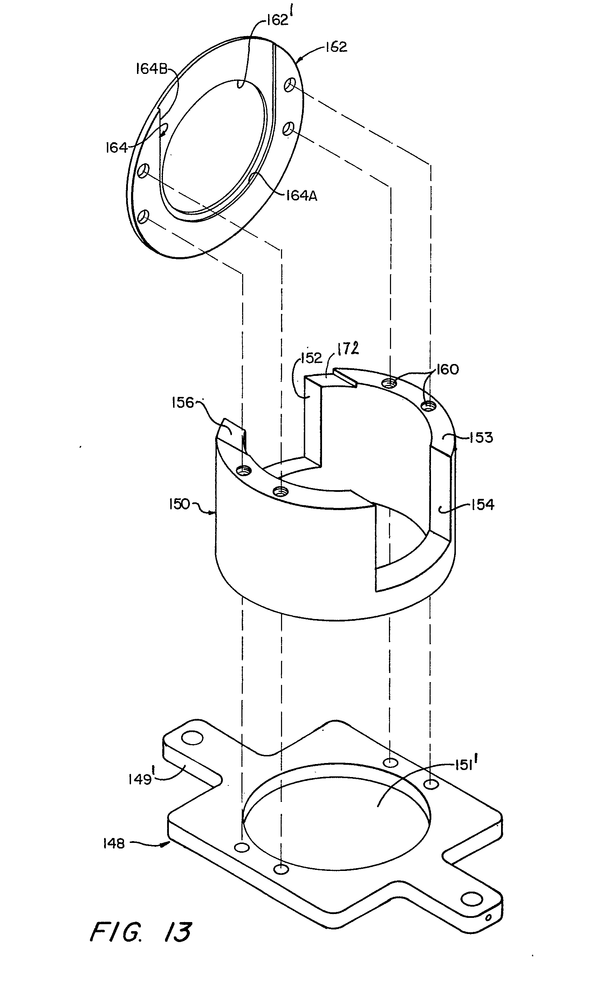

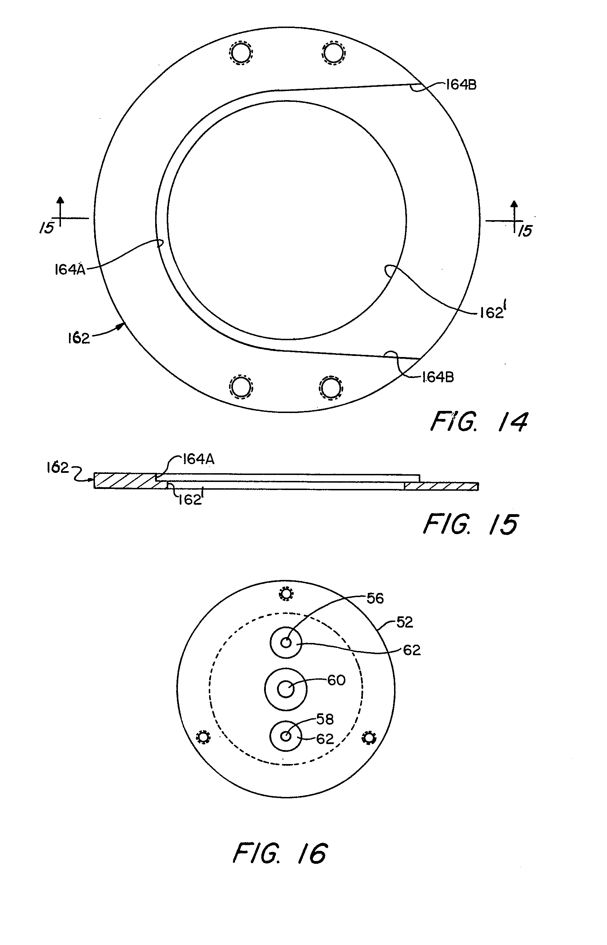

Turning now to Figures 1, 3 and 11-15, the work clamp assembly includes the clamp plate 148, and a clamp base 150 which is mounted on and attached to the clamp plate 148' and carries a clamp top 162. Clamp plate 148 has two ears 149' which have holes to accommodate the upper ends of guide rods 122A. The latter are secured to clamp plate 148 by set screws (not shown). Clamp plate 148 also has a centre hole 151' large enough to accommodate the electrode head assembly 68. Clamp plate 148 is attached by screws to clamp base 150.

Clamp base 150 is cylindrical and has an internal diameter identical to hole 151' in plate 148. Clamp base 150 has two diametrically opposed longitudinally extending slots 152 and 154 that terminate at one end of the base 150. Slots 152 and 154 have the same width (measured along the circumference) and length (measured along the axis of the base). A third slot 156 is formed in the base 150 at the top of and symmetrical with slot 152. Slot 156 is wider than slot 152.

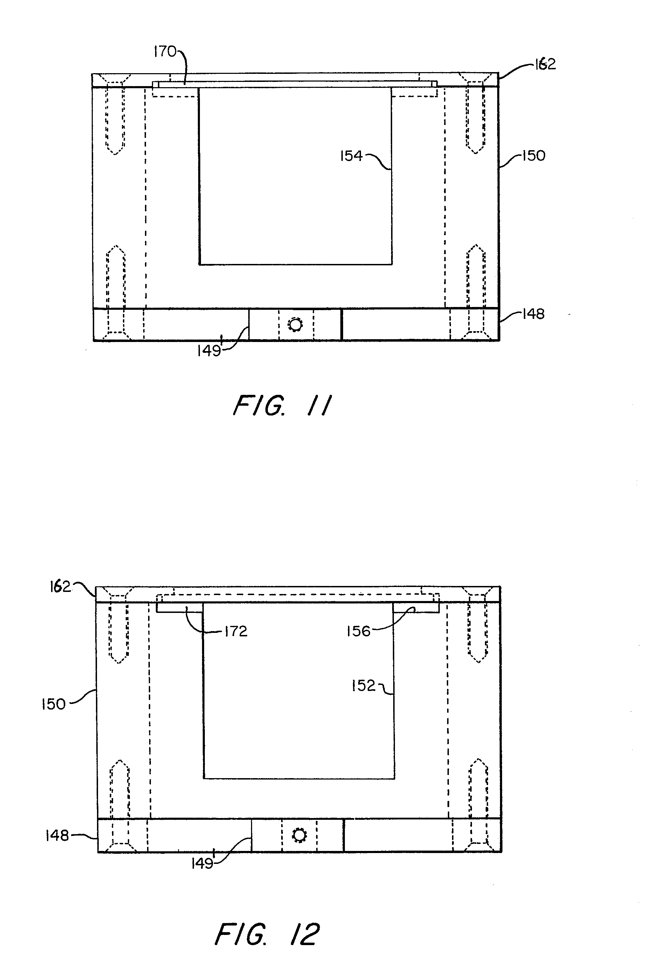

Clamp top 162 is bolted to clamp base 150 by means of screws which are screwed into tapped holes 160 in base 150. Clamp top 162 has a centre hole 162' and has a U-shaped recess 164 on its bottom side. Recess 164 may be considered to comprise a semicircular section 164A coaxial with hole 151 in clamp plate 148 and a second section 164B with straight opposite sides that are tangent to section 164A and terminate at the periphery of the top but diverge from one another with increasing distance from the section 164A. The straight opposite sides of section 164A are arranged so that at the periphery of the top they are spaced from one another by the same amount as the distance between the opposite sides of slot 154. Accordingly as shown in Figures 11 and 12, the clamp assembly has a first aperture 170 formed at one side by the recess 164 of top 162, with the bottom of the aperture being the upper surface 153 of the base 150, and a second aperture 172 formed at the opposite side by the recess 156, with the top of the aperture being the lower unrecessed surface of clamp top 162. Apertures 170 and 172 have approximately the same height and have the same width at the outer periphery of base 150. However, aperture 172 is lower than aperture 170 since the upper edge of aperture 172 is at the same level as the lower edge of aperture 170. As described hereinafter, aperture 170 serves as the entrance passageway for delivery of a semiconductor wafer into the region between upper electrode 18 and lower electrode, while aperture 172 serves as the exit passageway for removal of a semiconductor wafer from between the two electrodes.

An advantage of the invention is that it is adapted to be used in combination with a wafer transport mechanism which extends within the vacuum chamber. More particularly, movement of wafers into and out of the region between the upper and lower electrodes is achieved by a suitable transport mechanism (not shown) which is located within and extends transversely of the vacuum chamber in line with apertures 170 and 172 and is operatively connected via ports 180 and 182 (Figure 1) to transport mechanism located outside of the same chamber. The ports 180 and 182 are provided with suitable vacuum seals (not shown) to prevent loss of vacuum or gas from the chamber. It is contemplated that the wafer transport mechanism in the chamber will have a plurality of reciprocating elements that carry the wafers. In this connection it is to be noted that the aligned pairs of holes 80 and 82, 80A and 82A, and 80B and 82B are arranged to accommodate certain of the reciprocating elements of the transport mechanism used to carry the wafers into and out of the region between the upper and lower electrodes. Further details of the transport mechanism are omitted since the transport mechanism forms no part of the invention. Nevertheless, it is to be noted that various forms of conveyors are known which may be adapted for use with this invention. Preferably the transport mechanism has a construction as disclosed in U.S. patent 4 275 978, issued June 30, 1981 to Norman P. Brooks et al. U.S. patent 3 973 665 shows another conveyor system which may be adapted for use with this invention.

The function of the clamp assembly is threefold – it acts to stop a wafer on the transport mechanism when the wafer is in line with the two electrodes, it clamps the stopped wafer against the head of the lower electrode, and it allows the wafer to be transported out from between the electrodes.

To accomplish this function, a motor driven cam mechanism is provided which causes the clamp assembly to move vertically to one of three selected portions. As seen in Figure 1, the cam mechanism comprises a support structure 152A for a cam shaft 154A carrying three cams 156A, 156B and 156C, an electrically operated clutch 158, a sprocket gear 160 on the clutch shaft, a motor 162A, another sprocket gear 164A on the motor shaft, and a chain connecting the two sprockets. The clutch is selectively energised by suitable means (not shown) on command so as to cause the motor to rotate the cams. The cams are all circular and have the same diameter, but cam 156A is mounted on centre while cams 156B and 156C are mounted offcentre along one dimension only. The axis of rotation of cam 156C is spaced from its geometric centre by an amount which exceeds the corresponding eccentricity dimension of cam 156B. The exact amount of eccentivity required for cams 156B and 156C depends on the thickness of the wafer to be processed and the clearance required to allow the wafers to pass between clamp top 162 and the upper surface of plate 74. The cams are arranged on shaft 154A so that as the shaft rotates each cam will alternately engage cam plate 151 and thereby force the latter to raise or allow gravity to lower the clamp assembly. Cam 156A determines the lower or wafer-clamping position of the clamp assembly. Cam 156B is arranged so that its high spot is 120° removed from the start position of the cam shaft and it determines the waferstopping position of the clamp assembly. Cam 156C is arranged so that its high spot is 120° removed from the high spot of cam 156B and 240° removed from the start position of the cam shaft, and it determines the raised or wafer- discharging position of the clamp assembly.

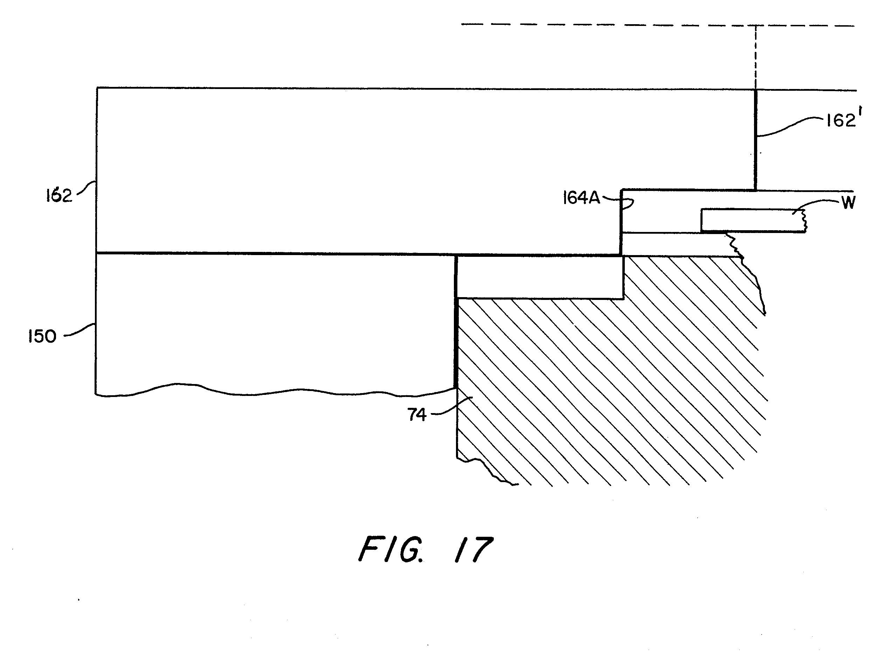

Figure 17 schematically illustrates part of the operation of the clamp assembly. When a wafer W is to be fed into position over the lower electrode, the cam shaft is in its start position and the clamp assembly is in the position shown in solid lines in Figure 17, in which position the unrecessed portion of the bottom end of clamp top 162 is flush with the top surface of plate 74, whereby a wafer W is free to enter the space between top 162 and the lower electrode via aperture 170. The wafer will be stopped by engagement with the curved surface of the section 164A of recess 164. Thereafter, cam 156A will cause the clamp assembly to move down and clamp the wafer to plate 74, in which position it is subjected to a selected treatment, e.g., reactive ion etching. Subsequently on rotation of the cam shaft, cam 156B will force the clamp assembly to rise sufficiently to free the wafer and allow it to pass out from between the clamp top and the lower electrode via aperture 72. Operation of cam shaft 154A may be controlled so that the frequency with which the clamp assembly moves up and down to stop a wafer, clamp the wafer to the lower electrode, and free the wafer for transport out of the chamber 1 complies with the time requirements of the treatment to which the wafers are to be subjected.

Apparatus made according to the present invention is especially useful for reactive ion etching using techniques such as those described in U.S. patents 4 283 249, 4 285 763, 3 940 506 and 3 971 684 and by J. Paraszczak et al, J. Vac. Sci. Tech., 19(4), Nov./Dec. 1981, pp. 1412-1417; J.D. Chinn et al, J. Vac. Sci. Tech., 19(4), Nov./Dec. 1981, pp. 1418-1422, and J. Parrens, J. Vac. Sci. Tech., 19(4), Nov./Dec. 1981, pp. 1403-1407. Although not shown, it is to be understood that the vacuum chamber is provided with a gas inlet which is connected to one or more sources of various gases which are used in etching or otherwise treating the upper face of the wafer which is clamped·by clamp top 162 to the top surface of plate 74. The opening 162' in clamp top 162 allows the gas or gases to directly contact the clamped wafer.

Obvious advantages of the invention are (a) the capability of automatically clamping each wafer or other article to be treated against the electrode in a predetermined position to facilitate a selected treatment such as etching, ion implantation, cleaning or the like, (b) improved transfer of heat from the wafer or other article to be treated by virtue of the cooling gas path afforded by the groove in the upper end of plate 74, (c) the ability to maintain the electrode head 68 at a selected temperature by circulating either a cooling fluid or a heating fluid through the groove in plate 72, (d) use of a sealing member 110 to assure a hermetic seal between plate 74 and the wafer or other product to be heated when the latter is held against electrode head 58 by the clamp assembly, (e) adaptability of the apparatus to an automated wafer processing line by virtue of its ability to accommodate a conveyor for the wafer and to automatically and sequentially stop, clamp and release the wafer, and (f) the ability to rotate the lower electrode about the pivot provided by plates 30 and 34 whereby the plane of the upper surface of the electrode can be levelled or tilted as required to accept a wafer from the conveyor. The invention also may be used in other apparatus where a work product needs to be cooled or heated within specific

-17-

limits, e.g., ion implantation, plasma etching, etc.

Other advantages and modifications will be obvious to persons skilled in the art.

CLAIMS

1. Apparatus for treating an article in a vacuum chamber comprising support means having an article-supporting surface, mechanical means for releasably clamping an article to be treated against said article-supporting surface, means for circulating a first cooling fluid between said article-supporting surface and an article which is clamped to said article-supporting surface, and means for circulating a second cooling fluid through portions of said support means so as to remove heat from said support means.

2. Apparatus according to Claim 1, wherein said support means is a first electrode.

3. Apparatus according to Claim 2, wherein said first electrode has a longitudinal axis and said article supporting surface extends transversely of said axis.

4. Apparatus according to Claim 3, further including a second electrode spaced from and confronting said article-supporting surface, and means for varying the angular position of said first electrode relative to said second electrode.

5. Apparatus according to Claim 4, comprising a vacuum chamber into which said electrodes project, said vacuum chamber having an opening and said first electrode including means extending out of said vacuum chamber via said opening, and further wherein said means for varying the angular position of said first electrode comprises means located outside of said vacuum chamber.

6. Apparatus according to Claim 5, wherein said means for varying the angular position of said first electrode comprises a levelling plate affixed to said first electrode and force-applying means attached to said plate and engaged with said chamber for changing the position of said levelling plate relative to said vacuum chamber.

7. Apparatus according to Claim 2, wherein said first electrode comprises first, second and third plates attached to one another, said article-supporting surface being a first surface of said first plate and said means for circulating a cooling fluid between said article-supporting surface and an article comprising a groove in said first surface.

8. Apparatus according to Claim 7, wherein said means for circulating a second cooling fluid comprises a passageway formed by and between said second and third plates.

9. Apparatus according to Claim 8, wherein said first electrode comprises a hollow tube extending at right angles to said article-supporting surface and further including conduit means in said tube for circulating cooling fluids through said groove and said passageway.

10. An article treated by an apparatus according to any one of Claims 1 to 9.

FIG. 1

FIG. 3

FIG. 2

FIG. 4

FIG. 5

FIG. 6

0100206

5/10

FIG. 7

FIG. 8

FIG. 9

FIG. 10

FIG. 11

FIG. 12

FIG. 13

164B

164A

162

162'

FIG. 14

162

164A

162'

FIG. 15

56

52

62

60

58

62

FIG. 16

FIG. 17

European Patent
Office

**EUROPEAN SEARCH REPORT**

Application number

| | DOCUMENTS CONSIDERED TO BE RELEVANT | | EP 83304226.0 |
|---|---|---|---|
| **Category** | Citation of document with indication, where appropriate, of relevant passages | Relevant to claim | CLASSIFICATION OF THE APPLICATION (Int. Cl. ³) |
| D,A | US - A - 4 261 762 (M.L. KING)<br>  * Abstract; fig. 2,4; claims *<br>  -- | 1 | C 23 C 13/08<br>C 23 C 15/00<br>C 23 F  1/08 |
| A | US - A - 4 311 427 (G.L. COAD et al.)<br>  * Fig.; claims *<br>  -- | 5,6 | |
| A | PATENT ABSTRACTS OF JAPAN, unexamined applications, C Field, vol. 5, no. 102, July 2, 1981<br>THE PATENT OFFICE JAPANESE GOVERNMENT<br>page 122 C 61<br>  * Kokai-no. 56-44 773 (MITSUBISHI DENKI K.K.) *<br>  ---- | 1 | |
| | | | **TECHNICAL FIELDS SEARCHED (Int. Cl. ³)**<br><br>C 23 C<br>C 23 F |

The present search report has been drawn up for all claims

| Place of search | Date of completion of the search | Examiner |
|---|---|---|
| VIENNA | 08-09-1983 | SLAMA |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82